# EUROPÄISCHE PATENTSCHRIFT

(11) **EP 1 183 782 B1**
(45) Veröffentlichungstag und Bekanntmachung des Hinweises auf die Patenterteilung: **16.02.2005**
(21) Anmeldenummer: 00938499.1
(22) Anmeldetag: 20.04.2000
(51) Int. Cl.: H03M 1/18

(54) **VERFAHREN UND SCHALTUNGSANORDNUNG ZUM REGELN DES EINEM ANALOG/DIGITAL-WANDLER ZUGEFÜHRTEN SIGNALPEGELS**
METHOD AND CIRCUIT FOR REGULATING THE SIGNAL LEVEL FED TO AN ANALOG-DIGITAL CONVERTER
PROCEDE ET CIRCUITERIE POUR REGLER LE NIVEAU DES SIGNAUX ACHEMINES JUSQU'A UN CONVERTISSEUR ANALOGIQUE/NUMERIQUE

(30) Priorität: 22.04.1999 DE 19918385
(43) Veröffentlichungstag der Anmeldung: 06.03.2002
(73) Patentinhaber: SIEMENS AKTIENGESELLSCHAFT, 80333 München (DE)
(72) Erfinder: ROHE, Christoph, D-44830 Bochum (DE); FALKENBERG, Andreas, D-58093 Hagen (DE); NIEMEYER, Ulf, D-44803 Bochum (DE)
(86) Internationale Anmeldenummer: PCT/DE2000/001249
(87) Internationale Veröffentlichungsnummer: WO 2000/065721

(56) Entgegenhaltungen:
- DE-C- 4 319 376
- US-A- 4 574 246
- US-A- 4 860 010
- PATENT ABSTRACTS OF JAPAN vol. 012, no. 469 (E-691), 8. Dezember 1988 (1988-12-08) -& JP 63 190456 A (FUJITSU LTD), 8. August 1988 (1988-08-08)
- PATENT ABSTRACTS OF JAPAN vol. 016, no. 031 (E-1159), 27. Januar 1992 (1992-01-27) & JP 03 243077 A (FUJITSU GENERAL LTD), 30. Oktober 1991 (1991-10-30)

## Beschreibung

Die vorliegende Erfindung betrifft ein Verfahren und eine Schaltungsanordnung zum Regeln des einem Analog/Digital-Wandler zugeführten Signalpegels.

Aus der US-A-4574246 ist bekannt ein Verfahren zum Regeln eines einem Analog/Digital-Wandlers zugeführten Signalpegels,
mit den Schritten:
a) Überwachen eines mehrere Bits umfassenden Ausgangssignals des Analog/Digital-Wandlers, und Erfassen der Rate, mit der für ein überwachtes Bit ein gegenüber dem Wert des höchstwertigen Bits geänderter Wert auftritt,
b) Einstellen des dem Analog/Digital-Wandler zugeführten Signalpegels in Abhängigkeit vom Ergebnis des Überwachung derart, dass der Signalpegel des Ausgangssignals innerhalb eines bestimmten Bereichs bleibt, und Einstellung des dem Analog/Digital-Wandlers (4) zugeführten Signalpegels in Abhängigkeit von der im Schritt a) erfassten Rate. Aus derselben Druckschrift geht außerdem eine Vorrichtung nach dem Oberbegriff des Patentanspruchs 7 hervor.

Digitale Hochfrequenz-Empfänger (HF-Empfänger) arbeiten nach dem derzeitigen Stand der Technik im HF-Eingangsteil analog. Ein Empfangssignal wird erst digitalisiert, nachdem es in das Basisband oder in eine Zwischenfrequenz heruntergemischt worden ist. Da der HF-Eingangsbereich aufgrund der unterschiedlichen Entfernungen zum Sender sehr groß sein kann, muß daß Empfangssignal vor der weiteren Verarbeitung, insbesondere vor seiner Digitalisierung, normiert werden. Zu diesem Zweck werden sogenannte AGC-Schaltungen (Automatic Gain Control) verwendet, deren Aufgabe es ist, den dem im Empfänger zur Digitalisierung vorgesehenen Analog/Digital-Wandler (A/D-Wandler) zugeführten Signalpegel derart zu regeln, daß der A/D-Wandler nicht übersteuert wird. Da die AGC-Schaltung nicht mit einer Geschwindigkeit arbeiten kann, welche den im Mobilfunkbereich auftretenden Fast-Fading-Effekten gerecht wird, muß eine Sicherheitsreserve zwischen dem der AGC-Schaltung vorgegebenen Sollwert und dem Maximalwert, der noch von dem A/D-Wandler umgesetzt werden kann, vorgesehen werden, so daß das umzusetzende Signal den gesammten Arbeitsbereich des A/D-Wandlers abzüglich der Sicherheitsreserve abdeckt. Die Sicherheitsreserve sollte derart bemessen sein, daß kurzzeitige Empfangssignalüberhöhungen innerhalb der Zeitkonstante des in der AGC-Schaltung verwendeten Reglers ausgeglichen werden können. So kann die Sicherheitsreserve je nach Anwendungsfall beispielsweise bei schnurlosen digitalen Telefonen 75% des Aussteuerbereichs des A/D-Wandlers betragen, wobei eine kurzzeitige Übersteuerung des A/D-Wandlers hingenommen werden kann.

Als AGC-Schaltungen sind sowohl dem A/D-Wandler vorgeschaltete Varianten als auch dem A/D-Wandler nachgeschaltete Varianten bekannt. AGC-Schaltungen, welche dem A/D-Wandler nachgeschaltet sind, besitzen den Vorteil, daß kein Abgleich zwischen dem Eingangspegel des A/D-Wandlers und dem Eingangspegel der AGC-Schaltung durchgeführt werden muß.

Aus der DE 43 19 376 Cl ist ein Verfahren und eine Schaltungsanordnung zur Analog/Digital-Wandlung von Signalen mit unterschiedlichen Signalpegeln bekannt, bei dem bzw. bei der das Ausgangssignal des Analog/Digital-Wandlers von einer logischen Schaltungseinheit, die mit dem Ausgang des Analog/Digital-Wandlers verbunden ist, überwacht wird und bei dem der dem Analog/Digital-Wandler zugeführte Signalpegel von der logischen Schaltungseinheit in Abhängigkeit von dem Ergebnis der Überwachung derart eingestellt wird, daß der Signalpegel des Ausgangssignals innerhalb eines bestimmten Bereiches bleibt.

Aus der JP 63190456 ist ein Signalverstärker bekannt, bei dem ein Ausgangssignal seines A/D-Wandlers innerhalb eines vorbestimmten Bereiches gehalten wird. In die Erzeugung eines Korrektursignals für eine Eingangsverstärkung gehen die Werte zweier Bits des Ausgangssignals des A/D-Wandlers ein, wobei jedoch eine durchgehende Überwachung nicht vorgesehen ist.

In Fig. 4 ist ein Beispiel für einen HF-Empfänger mit einer bekannten AGC-Schaltung dargestellt, welche dem A/D-Wandler nachgeschaltet ist. Ein Empfangs- oder Eingangssignal wird dem HF-Empfangsteil 2 des HF-Empfängers über eine Antenne 1 zugeführt. Wie bereits erwähnt worden ist, arbeitet das HF-Empfangsteil 2 analog. Das analoge Empfangssignal wird daher zur Digitalisierung einem A/D-Wandler 4 zugeführt, dessen Eingangssignalpegel über einen Regelkreis geregelt wird, wobei der Regelkreis einen Verstärker 3, der zwischen dem HF-Empfangsteil 2 und dem A/D-Wandler 4 angeordnet ist, mit variabler Verstärkung umfaßt. Bei dem in Fig. 4 gezeigten A/D-Wandler 4 handelt es sich um einen 8 Bit-A/D-Wandler, dessen 8 Bit-Ausgangswert einer Einheit 5 zugeführt wird, welche den Absolutwert des vom A/D-Wandler gelieferten Signalwerts berechnet. Der somit ermittelte Absolutwert wird mit negativem Vorzeichen einem Addierer 6 zugeführt, der des weiteren eine Sollwertvorgabe SP empfängt, so daß mit Hilfe des Addierers 6

Der Sollwert SP mit dem berechneten Absolutwert verglichen und abhängig von dem Vergleichsergebnis ein Stellsignal für den Verstärker 3 erzeugt wird, wobei gemäß Fig. 4 das Stellsignal durch Kombination zweier Teilsignale mit Hilfe eines Addierers 9 erzeugt wird. Das erste Teilsignal wird von einer Einheit 7 geliefert, welche das ihr zugeführte Differenzsignal integriert und skaliert, während das zweite Teilsignal von einem Tiefpaßfilter erster Ordnung (LP) 8 geliefert wird, welcher das ihm zugeführte Differenzsignal ebenfalls zudem skaliert. Die Einheit 7 repräsentiert somit den I-Anteil eines PI-Reglers, während die Einheit 8 den P-Anteil des PI-Reglers repräsentiert. Mit Hilfe des auf diese Weise gebildeten Regelkreises wird die Eingangsverstärkung des A/D-Wandlers 4 derart geregelt, daß der Absolutwert des AusgangsSignals des A/D-Wandlers 4 stets innerhalb eines bestimmten Bereichs bleibt bzw. sich innerhalb einer bestimmten Zeit dem Sollwert SP annähert.

Der vorliegenden Erfindung liegt die Aufgabe zugrunde, ein neues Verfahren und eine neue Schaltungsanordnung zum Regeln des einem Analog/Digital-Wandler zugeführten Signalpegels bereitzustellen, womit eine möglichst einfache Regelung des dem Analog/Digital-Wandler zugeführten Signalpegels möglich sein soll. Insbesondere soll die Schaltungsanordnung mit einer minimalen Anzahl an Komponenten auskommen.

Die oben genannte Aufgabe wird gemäß der vorliegenden Erfindung durch ein Verfahren mit den Merkmalen des Anspruches 1 bzw. eine Schaltungsanordnung mit den Merkmalen des Anspruches 7 gelöst. Die Unteransprüche beschreiben bevorzugte und vorteilhafte Ausführungsformen der Erfindung.

Die Erfindung geht davon aus, daß das Empfangssignal bei digitalen Funksystemen, wie z.B. bei DCMA-Systemen (Code Division Multiple Access) , über die Zeit unabhängig von der Information einer bestimmten statistischen Verteilung entsprechen soll. Daher wird erfindungsgemäß vorausgesetzt, daß es ausreichend ist, die Regelung des dem A/D-Wandler zugeführten Signalpegels derart zu gestalten, daß über einen gewissen Zeitraum lediglich eine bestimmte Anzahl von Ausgangssignalen des A/D-Wandlers oberhalb eines bestimmten normierten Signalpegels liegen. Dies kann dadurch überwacht werden, daß die Änderungswahrscheinlichkeit oder Änderungsrate des Ausgangssignals des A/D-Wandlers erfaßt wird.

Insbesondere wird angenommen, daß es ausreichend ist, die Wahrscheinlichkeit, mit der sich die Information eines bestimmten Bits des Ausgangssignals des A/D-Wandlers ändert, derart zu regeln, daß sie stets innerhalb eines bestimmten Bereichs liegt und einen vorgegebenen Grenzwert nicht überschreitet. Dies ist möglich, da die Ausgangsbits des A/D-Wandlers gewissen Schwellen entsprechen, die mit dem Modulo-Faktor ihrer Wertigkeit öfter vorkommen. Vorteilhafterweise wird hierzu eines der höherwertigeren Bits des Ausgangssignals des A/D-Wandlers überwacht.

Die Wahrscheinlichkeit, mit der sich das überwachte Ausgangsbit des A/D-Wandlers verändert, muß kleiner als 50% sein. Die Stabilität des Systems ist jedoch umso besser, je kleiner dieser Grenzwert ist. Wird jedoch der Grenzwert zu klein gewählt, werden unter Umständen nicht sämtliche Bits des A/D-Wandlers genutzt und somit Systemressourcen vergeudet. Als vorteilhaft hat sich ein Grenzwert von 25% herausgestellt, da dieser Wert einen guten Kompromiß zwischen den zuvor erwähnten Erfordernissen darstellt. Dieser Grenzwert wird daher vorteilhafterweise als Sollwertvorgabe für die Regelung des Eingangssignalpegels des A/D-Wandlers verwendet, d.h. der Eingangssignalpegel des A/D-Wandlers wird derart geregelt, daß sich das überwachte Ausgangsbit des A/D-Wandlers im zeitlichen Mittel maximal mit einer Wahrscheinlichkeit von 25%, d.h. alle vier Abtastwerte, verändert. Bei einem 8 Bit-A/D-Wandler kann somit beispielsweise die Änderungswahrscheinlichkeit oder Änderungsrate des sechsten Bits auf 25% geregelt werden.

Das zuvor beschriebene Prinzip der Erfindung ermöglicht den Aufbau einer AGC-Schaltung mit einer minimalen Anzahl an zudem preiswerten Komponenten. Dies resultiert daraus, daß gemäß der vorliegenden Erfindung nicht auf einen konkreten Ausgangswert des A/D-Wandlers, sondern auf die Änderungsrate bzw. Änderungswahrscheinlichkeit des A/D-Wandlers geregelt wird. Die AGC-Schaltung kann insbesondere derart aufgebaut sein, daß sie die Änderung des Ausgangssignals des A/D-Wandlers, insbesondere die Änderung eines besimmten Ausgangsbits, mit dem Zeitverlauf ins Verhältnis setzt. Wird auf diese Weise eine geringe Änderungsrate erfaßt, wird von einer entsprechenden Regelschaltung die Eingangsverstärkung des A/D-Wandlers erhöht bzw. im anderen Fall verringert.

Die Erfindung wird nachfolgend unter Bezugnahme auf die beigefügte Zeichnung anhand bevorzugter Ausführungsbeispiele erläutert.
Fig. 1 zeigt einen Hochfrequenz-Empfänger mit einer AGC-Schaltung gemäß einem Beispiel hilfreich zum Verständnis des Erfindung,
Fig. 2 zeigt einen Hochfrequenz-Empfänger mit einer AGC-Schaltung gemäß einem ersten Ausführungsbeispiel der vorliegenden Erfindung,
Fig. 3 zeigt einen Hochfrequenz-Empfänger mit einer AGC-Schaltung gemäß einem zweiten Ausführungsbeispiel der vorliegenden Erfindung, und
Fig. 4 zeigt einen Hochfrequenz-Empfänger mit einer AGC-Schaltung gemäß dem Stand der Technik.

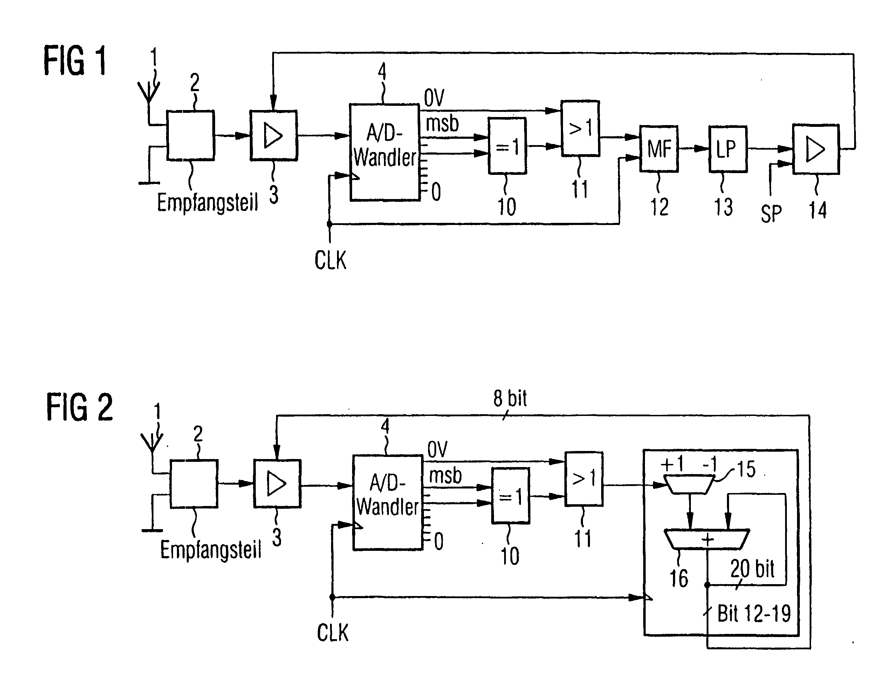

Gemäß Fig. 1 umfaßt der dargestellte Empfänger wieder ein HF-Empfangsteil 2, dem über eine Antenne 1 ein HF-Empfangssignal zugeführt wird. Das HF-Empfangsteil 2 arbeitet analog und mischt das Empfangssignal in das Basisband, wobei das von dem HF-Empfangsteil 2 gelieferte Basisbandsignal einem A/D-Wandler 4 zugeführt wird, der dieses Signal in eine digitale Datenfolge umsetzt. Der Verstärkungsfaktor eines vor den A/D-Wandler 4 geschalteten Eingangsverstärkers 3 ist variabel und wird durch einen PI-Regler 14 derart eingestellt, daß am Eingang des A/D-Wandlers 4 ein optimaler Signalpegel anliegt.

Nachfolgend wird davon ausgegangen, daß als optimaler Signalpegel ein Signalpegel angesehen wird, der 1/4, d.h. 25%, des maximalen Signalpegels entspricht. Die somit verwendete Sicherheitsreserve von 75% sollte ausreichen, um die durch Fast-Fading-Effekte hervorgerufenen Signalüberhöhungen auszugleichen. In diesem Fall kann die Änderungsrate des zweiten Bits unterhalb des höchstwertigen Bits (most significant bit, msb) überwacht werden, um die Einhaltung der 25%-Schwelle des Eingangssignalpegels des A/D-Wandlers 4 zu gewährleisten. Die für den Fall eines Eingangssignalpegels, der 25% des maximalen Signalpegels entspricht, auftretende Änderungsrate des zweiten Bits unterhalb des höchstwertigen Bits, d.h. bei einem 8 Bit-A/D-Wandler des Bits Nr. 5, wird daher als Sollwertvorgabe SP verwendet und dem PI-Regler 14 zugeführt.

Die Änderungsrate des entsprechenden Bits des Ausgangssignals des A/D-Wandlers 4 wird gemäß Fig. 1 von einer Logikschaltung überwacht, welche abhängig von den Umschaltzeitpunkten des überwachten Bits entsprechende Impulse liefert. Diese Logikschaltung umfaßt ein XOR-Gatter 10, welches den Zustand des überwachten Bits mit demjenigen des höchstwertigen Bits vergleicht und den Ausgangswert "1" liefert, falls sich das höchstwertige Bit bzw. das Vorzeigenbit und das überwachte Bit unterscheiden. Des weiteren umfaßt die Logikschaltung ein dem XOR-Gatter 10 nachgeschaltetes OR-Gatter 11, welches jedoch nur erforderlich ist, falls ein A/D-Wandler 4 mit Begrenzungsfunktion (Clipping) verwendet wird, wobei in diesem Fall der A/D-Wandler 4 einen bestimmten durch seine Wortbreite definierten Maximalwert ausgibt, falls der Eingangswert größer als der Maximalwert ist. Das OR-Gatter 11 empfängt als Eingangssignale ein Steuersignal OV , welches im Begrenzungsfall den Wert "1" besitzt, sowie das Ausgangssignal des XOR-Gatters 10.

Dem OR-Gatter 11 ist ein Monoflop 12 nachgeschaltet, welches synchron zu demjenigen Zeitpunkt gesetzt wird, bei dem die vorgeschaltete Logik eine Information auf dem interessierenden Bit erfaßt. Dies wird dadurch erreicht, daß der A/D-Wandler 4 und das Monoflop 12 mit demselben Taktsignal CLK getriggert werden. Das Monoflop 12 erzeugt jedesmal, wenn das überwachte Bit eine Information enthält, d.h. den Wert "1" besitzt, einen Impuls konstanter Dauer, wobei die Impulsdauer kürzer als die Dauer einer Abtastperiode ist.

Das Ausgangssignal des Monoflops 12 ist einem Tiefpaßfilter 13 erster oder höherer Ordnung zugeführt, welches die an ihm anliegende Impulsfolge zeitlich mittelt und somit ein Ausgangssignal erzeugt, das proportional zu der mittleren Anzahl der letzten Impulse ist. Die Zeitkonstante des Tiefpaßfilters sollte der Länge eines Zeitschlitzes (Slots) des Empfangssignals bzw. einem Vielfachen (≥10) der Abtastrate des A/D-Wandlers 4 entsprechen.

Das auf diese Weise erzeugte Istwertsignal der Änderungsrate des sechsten Bits, d.h. des Ausgangsbits Nr. 5, des A/D-Wandlers 4 ist dem bereits erwähnten PI-Regler 14 zugeführt, der die durch das Istwertsignal angezeigte Ist-Änderungsrate des überwachten Bits mit dem vorgegebenen Sollwert SP vergleicht und abhängig von der Differenz ein Einstellsignal für den Eingangsverstärker 3 derart erzeugt, daß die Eingangsverstärkung erhöht wird, falls der Impulsmittelwert unterhalb des Sollwerts SP liegt, während die Eingangsverstärkung verringert wird, falls der Impulsmittelwert oberhalb des Sollwerts SP liegt.

Das Ausgangssignal des PI-Reglers 14 kann mit Hilfe eines weiteren A/D-Wandlers, der mit einer niedrigen Abtastrate arbeitet, in ein digitales AGC-Signal für jeden beliebigen Microcontroller umgesetzt werden.

Bei der in Fig. 1 gezeigten Schaltungsvariante handelt es sich um einen Entwurf mit einer analogen PI-Regelschaltung. Um die mit analogen Bauteilen verbundenen Nachteile hinsichtlich der Einhaltung von Toleranzen und Schaltungsdrift zu vermeiden, kann die in Fig. 2 gezeigte Schaltungsvariante mit digitalen Komponenten verwendet werden. Zur Vereinfachung der Schaltung wurde der PI-Regler durch einen I-Regler ersetzt.

Gemäß Fig. 2 ist der in Fig. 1 gezeigte analoge Abschnitt mit dem Monoflop 12, dem Tiefpaßfilter 13 und dem PI-Regler 14 durch eine entsprechende Ersatzschaltung mit einem Multiplexer 15 und einem Akkumulator 16 bzw. einen Addierer mit rückgekoppeltem Ausgang ersetzt. Bei dem Akkumulator 16 handelt es sich in diesem Fall um einen 20 Bit-Akkumulator. Die Größe des Akkumulators 16 ist derart zu bemessen, daß es innerhalb der Regelkreis-Zeitkonstante zu keinem Überlauf kommt.

An den Eingängen des Multiplexers 15 liegen fest die Werte "+1" und "-1" an. Der Multiplexer 15 wird von dem Ausgangssignal des OR-Gatters 11 derart angesteuert, daß er den Wert "-1" an seinen Ausgang durchschaltet, falls die Logikschaltung mit dem XOR-Gatter 10 und dem OR-Gatter 11 eine Information, d.h. den Wert "1", auf dem überwachten Bit erkannt hat, während im anderen Fall der Wert "+1" durchgeschaltet wird. Der Ausgabewert des Multiplexers 15 wird dem Akkumulator bzw. Addierer 16 zugeführt, der vorzugsweise intern eine Logik zur Vermeidung von Überlauf aufweist. Der akkumulierte Ausgabewert des Akkumulators 16 wird zur Erzeugung des Einstellsignals für den Eingangsverstärker 3 verwendet, wobei hierzu dem Eingangsverstärker 3 insbesondere die oberen acht Bits des Ausgabewerts des Akkumulators 16 zugeführt werden.

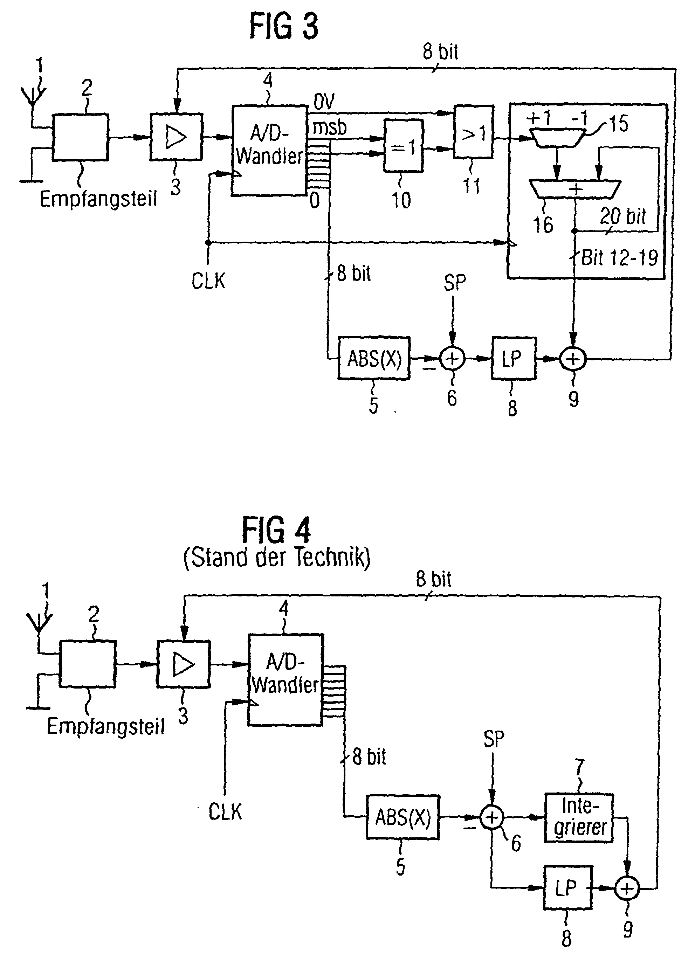

Bei dem in Fig. 2 gezeigten Ausführungsbeispiel ist der Regelkreis lediglich mit einem I-Anteil ausgestattet. Um den Regelkreis um einen P-Anteil zu ergänzen, kann die in Fig. 2 gezeigte Schaltung analog zu der in Fig. 4 gezeigten Schaltung um einen Abschnitt erweitert werden, welcher sämtliche Ausgangsbits des A/D-Wandlers 4 überwacht und daraus den Absolutwert berechnet und mit dem vorgegebenen Sollwert SP vergleicht. Der somit ermittelte Differenzwert kann wiederum einem digitalen Tiefpaßfilter erster Ordnung zugeführt, skaliert und das somit skalierte Ergebnis zu dem I-Anteil des Akkumulators 16 hinzuaddiert werden. Eine entsprechende Schaltung ist in Fig. 3 gezeigt, wobei die der in Fig. 4 dargestellten Schaltung entsprechenden Komponenten mit denselben Bezugszeichen versehen sind. Anstelle der Absolutwertbildung durch die Einheit 5 kann auch das Ausgangssignal des A/D-Wandlers 4 quadriert werden.

## Patentansprüche

1. Verfahren zum Regeln eines einem Analog/Digital-Wandler zugeführten Signalpegels,
mit den Schritten:
a) Überwachen eines mehrere Bits umfassenden Ausgangssignals des Analog/Digital-Wandlers, und Erfassen der Rate, mit der für ein überwachtes Bit ein gegenüber dem Wert des höchstwertigen Bits geänderter Wert auftritt,
b) Einstellen des dem Analog/Digital-Wandler zugeführten Signalpegels in Abhängigkeit vom Ergebnis der Überwachung derart, dass der Signalpegel des Ausgangssignals innerhalb eines bestimmten Bereichs bleibt, und Einstellung des dem A-nalog/Digital-wandlers (4) zugeführten Signalpegels in Abhängigkeit von der im Schritt a) erfassten Rate,
**dadurch gekennzeichnet,**
**dass** ein Mittelwert für die Rate des überwachten Bits gemessen wird,
an einen Multiplexer (15) als Eingangswerte feste Werte +1 und -1 angelegt werden, welche selektiv, abhängig von der gemessenen Rate, an einen Ausgang des Multiplexers (15) durchgeschaltet werden, und
ein Akkumulator (16) den von dem Multiplexer (15) durchgeschalteten Eingangswert empfängt, entsprechend seinen Zählerstand verändert und abhängig von seinem Zählerstand den dem Analog/Digital-Wandler zugeführten Signalpegel einstellt.

2. Verfahren nach Anspruch 1,
**dadurch gekennzeichnet,**
**daß** im Schritt b) die im Schritt a) erfaßte Rate mit einem Sollwert (SP), welcher einer Soll-Rate entspricht, verglichen wird, um abhängig von dem Vergleichsergebnis den dem Analog/Digital-Wandler (4) zugeführten Signalpegel einzustellen.

3. Verfahren nach Anspruch 2,
**dadurch gekennzeichnet,**
**daß** im Schritt b) als Sollwert (SP) für die Rate eine Rate entsprechend einer mittleren Änderungswahrscheinlichkeit < 50% gewählt wird, so daß der dem Analog/Digital-Wandler (4) zugeführte Signalpegel derart geregelt wird, daß sich das überwachte Bit des Ausgangssignals des Analog/Digital-Wandlers (4) im Mittel geringer als mit jedem zweiten Taktzyklus (CLK) des Analog/Digital-Wandlers (4) verändert.

4. Verfahren nach Anspruch 3,
**dadurch gekennzeichnet,**
**daß** im Schritt b) als Sollwert (SP) für die Rate eine Rate entsprechend einer mittleren Änderungswahrscheinlichkeit von 25% gewählt wird, so daß der dem Analog/Digital-Wandler (4) zugeführte Signalpegel derart geregelt wird, daß sich das überwachte Bit des Ausgangssignals des Analog/Digital-Wandlers (4) im Mittel alle vier Taktzyklen (CLK) des Analog/Digital-Wandlers (4) verändert.

5. Verfahren nach Anspruch 4,
**dadurch gekennzeichnet,**
**daß** der Analog/Digital-Wandler (4) ein 8 Bit-Ausgangssignal liefert, und
**daß** im Schritt a) die Änderungsrate des sechsten Bits des Ausgangssignals des Analog/Digital-Wandlers (4) erfaßt wird.

6. Verfahren nach Anspruch 2,
**dadurch gekennzeichnet,**
**daß** im Schritt b) der dem Analog/Digital-Wandler (4) zugeführte Signalpegel erhöht wird, falls die im Schritt a) erfaßte Rate kleiner als der Sollwert (SP) ist, und
**daß** im Schritt b) der dem Analog/Digital-Wandler (4) zugeführte Signalpegel verringert wird, falls die im Schritt a) erfaßte Rate größer als der Sollwert (SP) ist.

7. Schaltungsanordnung zum Regeln des einem Analog/Digital-Wandler zugeführten Signalpegels,
mit Verstärkermitteln (3), um dem Analog/Digital-wandler (4) ein analoges Eingangssignal mit einem bestimmten Signalpegel zuzuführen,
mit Überwachungsmitteln (10-13) zum Überwachen des mehrere Bits umfassenden Ausgangssignals des Analog/Digital-Wandlers (4), und
mit einer Regelschaltung (14-16) zum Erzeugen eines Einstellsignals für die Verstärkermittel (3), wobei die Regelschaltung (14-16) in Abhängigkeit von dem Überwachungsergebnis der Überwachungsmittel (10-13) ein Einstellsignal für die Verstärkermittel (3) derart erzeugt, daß der dem Analog/Digital-Wandler (4) zugeführte Signalpegel innerhalb eines bestimmten Bereichs bleibt,
die Überwachungsmittel (10-13) derart ausgestaltet sind, daß sie die Rate, mit der für ein überwachtes Bit ein gegenüber einem Wert des höchstwertigen Bits geänderter Wert auftritt, erfassen, und
daß die Regelschaltung (14-16) derart ausgestaltet ist, daß sie abhängig von der von den Überwachungsmitteln (10-13) erfaßten Rate das Einstellsignal für die Verstärkermittel (3) erzeugt
**dadurch gekennzeichnet,**
**dass** die Überwachungsmittel (10-13) eine Mittelwertbildungsschaltung (12, 13) zum zeitlichen Mitteln der von der Logikschaltung (10, 11) erfaßten Rate des überwachten Bits des Ausgangssignals des Analog/Digital-Wandlers (4) umfassen, daß die Regelschaltung einen von einem Ausgangssignal der Logikschaltung (10, 11) angesteuerten Multiplexer (15) und einen Akkumulator (16) umfaßt,
wobei an den Multiplexer (15) als Eingangswerte die festen Werte +1 und -1 angelegt sind, welche selektiv abhängig von dem Wert des Ausgangssignals der Logikschaltung (10, 11) an den Ausgang des Multiplexers (15) durchgeschaltet werden, und daß der Akkumulator (16) den von dem Multiplexer (15) durchgeschalteten Eingangswert empfängt, entsprechend seinen Zählerstand verändert und abhängig von seinem Zählerstand das Einstellsignal für die Verstärkermittel (3) erzeugt.

8. Schaltungsanordnung nach Anspruch 7,
**dadurch gekennzeichnet,**
**daß** der Analog/Digital-wandler (4) ein 8 Bit-Ausgangssignal liefert, und
**daß** die Überwachungsmittel (10-13) die Rate für das sechst niedrigste Bit des Ausgangssignals des Analog/Digital-Wandlers (4) erfassen.

9. Schaltungsanordnung nach einem der Ansprüche 7 oder 8,
**dadurch gekennzeichnet,**
**daß** die Überwachungsmittel (10-13) eine Logikschaltung (10, 11) umfassen, welche zur Bestimmung der Rate eine Änderung des niedriger wertigen Bits gegenüber dem höchstwertigen Bit des Ausgangssignals des Analog/Digital-wandlers (4) erfaßt.

10. Schaltungsanordnung nach Anspruch 9,
**dadurch gekennzeichnet,**
**daß** die Logikschaltung (10, 11) ein XOR-Gatter (10) umfaßt, dem als Eingangssignale das niedriger wertige Bit und das höchstwertige Bit des Ausgangssignals des Analog/Digital-Wandlers (4) zugeführt sind.

11. Schaltungsanordnung nach Anspruch 10,
**dadurch gekennzeichnet,**
**daß** die Logikschaltung (10, 11) ein OR-Gatter (11) umfaßt, dem als Eingangssignale das Ausgangssignal des XOR-Gatters (10) und ein Überlaufsignal des Analog/Digital-Wandlers (4) zugeführt sind.

12. Schaltungsanordnung nach einem der Ansprüche 7-11,
**dadurch gekennzeichnet,**
**daß** die Mittelwertbildungsschaltung (12, 13) ein Monoflop (12) und ein damit in Reihe geschaltetes Tiefpaßfilter (13) umfaßt, wobei das Monoflop (12) mit der Logikschaltung (10, 11) verbunden und mit demselben Takt (CLK) wie der Analog/Digital-Wandler (4) getaktet ist.

13. Schaltungsanordnung nach einem der Ansprüche 7-12,
**dadurch gekennzeichnet,**
**daß** die Regelschaltung einen PI-Regler (14) umfaßt, der die von den Überwachungsmitteln (10-13) erfaßte Rate mit einem Sollwert (SP) vergleicht und abhängig von der Abweichung zwischen der von den Überwachungsmitteln (10-13) erfaßten Rate und dem Sollwert das Einstellsignal für die Verstärkermittel (3) erzeugt.

14. Schaltungsanordnung nach Anspruch 13,
**dadurch gekennzeichnet,**
**daß** der PI-Regler (14) ein den dem Analog/Digital-Wandler (4) zugeführten Signalpegel erhöhendes Einstellsignal für die Verstärkermittel (3) erzeugt, falls die von den Überwachungsmitteln (10-13) erfaßte Rate kleiner als der Sollwert (SP) ist, und
**daß** der PI-Regler (14) ein den dem Analog/Digital-Wandler (4) zugeführten Signalpegel verringerndes Einstellsignal für die Verstärkermittel (3) erzeugt, falls die von den Überwachungsmitteln (10-13) erfaßte Rate größer als der Sollwert (SP) ist.

15. Schaltungsanordnung nach einem der Ansprüche 7-14,
**dadurch gekennzeichnet,**
**daß** der Akkumulator (16) ein 20 Bit-Akkumulator ist, wobei die oberen acht Bits des Zählerstands des Akkumulators (16) als Einstellsignal den Verstärkermitteln (3) zugeführt sind.

16. Schaltungsanordnung nach einem der Ansprüche 7-15,
**dadurch gekennzeichnet,**
**daß** eine Absolutwertbildungseinheit (5) mit dem Ausgang des Analog/Digital-Wandlers (4) verbunden ist, um den Absolutwert des Ausgangssignals des Analog/Digital-Wandlers (4) zu bilden,
**daß** ein Vergleicher (6) mit dem Ausgang der Absolutwertbildungseinheit (5) verbunden ist, um den von der Absolutwertbildungseinheit (5) gelieferten Absolutwert mit einem Sollwert (SP) zu vergleichen, und
**daß** ein Addierer (9) zum Addieren des Ausgangssignals des Vergleichers (6) und des Ausgangssignals des Akkumulators (16) vorgesehen ist, wobei das Additionsergebnis des Addierers (9) als das Einstellsignal den Verstärkermitteln (3) zugeführt ist.

17. Schaltungsanordnung nach Anspruch 16,
**dadurch gekennzeichnet,**
**daß** das Ausgangssignal des Vergleichers (6) über ein Tiefpaßfilter (8) dem Addierer (9) zugeführt ist.

18. Verwendung einer Schaltungsanordnung nach einem der Ansprüche 7-17 in einem Hochfrequenz-Empfänger,
wobei ein von einer Hochfrequenz-Empfangseinheit (2) empfangenes und auf ein Basisbandsignal heruntergemischtes Empfangssignal dem Analog/Digital-Wandler (4) zur Umsetzung in eine Digitalsignal über die Verstärkermittel (3) der Schaltungsanordnung zugeführt wird.

## Claims

1. A method for regulating a signal level fed to an analogue/digital converter,
with the steps of:
a) monitoring an output signal, comprising several bits, of the analogue/digital converter, and measuring the rate at which a value which has changed in comparison with the value of the most-significant bit occurs for a monitored bit,
b) setting the signal level fed to the analogue/digital converter in dependence on the result of the monitoring in such a way that the signal level of the output signal remains within a certain range, and setting the signal level fed to the analogue/digital converter (4) in dependence on the rate measured in step a),
**characterized in that**, a mean value for the rate of the monitored bit is measured, fixed values +1 and -1 are applied to a multiplexer (15) as input values and switched through selectively to an output of the multiplexer (15), in dependence on the measured rate, and an accumulator (16) receives the input value switched through by the multiplexer (15), changes it in a way corresponding to its counter reading and, in dependence on its counter reading, sets the signal level fed to the analogue/digital converter.

2. Method according to Claim 1, **characterized in that**, in step b), the rate measured in step a) is compared with a setpoint value (SP), which corresponds to a setpoint rate, in order, in dependence on the result of the comparison, to set the signal level fed to the analogue/digital converter (4).

3. Method according to Claim 2, **characterized in that**, in step b), a rate corresponding to a mean probability of change of < 50% is chosen as the setpoint value (SP) for the rate, so that the signal level fed to the analogue/digital converter (4) is regulated in such a way that the monitored bit of the output signal of the analogue/digital converter (4) changes on average less than with every second clock cycle (CLK) of the analogue/digital converter (4).

4. Method according to Claim 3, **characterized in that**, in step b), a rate corresponding to a mean probability of change of 25% is chosen as the setpoint value (SP) for the rate, so that the signal level fed to the analogue/digital converter (4) is regulated in such a way that the monitored bit of the output signal of the analogue/digital converter (4) changes on average every four clock cycles (CLK) of the analogue/digital converter (4).

5. Method according to Claim 4, **characterized in that**, the analogue/digital converter (4) supplies an 8-bit output signal, and **in that**, in step a), the rate of change of the sixth bit of the output signal of the analogue/digital converter (4) is measured.

6. Method according to Claim 2, **characterized in that**, in step b), the signal level fed to the analogue/digital converter (4) is increased if the rate measured in step a) is less than the setpoint value (SP), and **in that**, in step b), the signal level fed to the analogue/digital converter (4) is reduced if the rate measured in step a) is greater than the setpoint value (SP).

7. Circuit arrangement for regulating the signal level fed to an analogue/digital converter, with amplifier means (3), in order to feed to the analogue/digital converter (4) an analogue input signal with a certain signal level, with monitoring means (10-13) for monitoring the output signal, comprising several bits, of the analogue/digital converter (4), and with a regulating circuit (14-16) for generating a setting signal for the amplifier means (3), the regulating circuit (14-16) generating a setting signal for the amplifier means (3) in dependence on the monitoring result of the monitoring means (10-13) in such a way that the signal level fed to the analogue/digital converter (4) remains within a certain range, the monitoring means (10-13) are designed in such a way that they measure the rate at which a value which has changed in comparison with the value of the most-significant bit occurs for a monitored bit, and in that the regulating circuit (14-16) is designed in such a way that, in dependence on the rate measured by the monitoring means (10-13), it generates the setting signal for the amplifier means (3),
**characterized in that** the monitoring means (10-13) comprise a mean-value-forming circuit (12, 13) for forming the mean time value of the rate, measured by the logic circuit (10, 11), of the monitored bit of the output signal of the analogue/digital converter (4),
**in that** the regulating circuit comprises a multiplexer (15), driven by an output signal of the logic circuit (10, 11), and an accumulator (16), the fixed values +1 and -1 being applied to the multiplexer (15) as input values and switched through selectively to the output of the multiplexer (15), in dependence on the value of the output signal of the logic circuit (10, 11), and **in that** the accumulator (16) receives the input value switched through by the multiplexer (15), changes it in a way corresponding to its counter reading and, in dependence on its counter reading, generates the setting signal for the amplifier means (3).

8. Circuit arrangement according to Claim 7, **characterized in that** the analogue/digital converter (4) supplies an 8-bit output signal, and **in that** the monitoring means (10-13) measure the rate for the sixth least-significant bit of the output signal of the analogue/digital converter (4).

9. Circuit arrangement according to one of Claims 7 or 8, **characterized in that** the monitoring means (10-13) comprise a logic circuit (10, 11), which measures a change of the less-significant bit with respect to the most-significant bit of the output signal of the analogue/digital converter (4) in order to determine the rate.

10. Circuit arrangement according to Claim 9, **characterized in that** the logic circuit (10, 11) comprises an XOR gate (10), which is fed as input signals the less-significant bit and the most-significant bit of the output signal of the analogue/digital converter (4).

11. Circuit arrangement according to Claim 10, **characterized in that** the logic circuit (10, 11) comprises an OR gate (11), which is fed as input signals the output signal of the XOR gate (10) and an overflow signal of the analogue/digital converter (4).

12. Circuit arrangement according to one of Claims 7-11, **characterized in that** the mean-value-forming circuit (12, 13) comprises a one-shot multivibrator (12) and a low-pass filter (13) arranged in series with the latter, the one-shot multivibrator (12) being connected to the logic circuit (10, 11) and timed with the same clock (CLK) as the analogue/digital converter (4).

13. Circuit arrangement according to one of Claims 7-12, **characterized in that** the regulating circuit comprises a PI controller (14), which compares the rate measured by the monitoring means (10-13) with a setpoint value (SP) and, in dependence on the deviation between the rate measured by the monitoring means (10-13) and the setpoint value, generates the setting signal for the amplifier means (3).

14. Circuit arrangement according to Claim 13, **characterized in that** the PI controller (14) generates a setting signal for the amplifier means (3) increasing the signal level fed to the analogue/digital converter (4) if the rate measured by the monitoring means (10-13) is less than the setpoint value (SP), and **in that** the PI controller (14) generates a setting signal for the amplifier means (3) reducing the signal level fed to the analogue/digital converter (4) if the rate measured by the monitoring means (10-13) is greater than the setpoint value (SP).

15. Circuit arrangement according to one of Claims 7-14, **characterized in that** the accumulator (16) is a 20-bit accumulator, the upper eight bits of the counter reading of the accumulator (16) being fed as the setting signal to the amplifier means (3).

16. Circuit arrangement according to one of Claims 7-15, **characterized in that** an absolute-value forming unit (5) is connected to the output of the analogue/digital converter (4), in order to form the absolute value of the output signal of the analogue/digital converter (4), **in that** a comparator (6) is connected to the output of the absolute-value forming unit (5), in order to compare the absolute value supplied by the absolute-value forming unit (5) with a setpoint value (SP), and **in that** an adder (9) is provided for adding the output signal of the comparator (6) and the output signal of the accumulator (16), the result of the addition of the adder (9) being fed as the setting signal to the amplifier means (3).

17. Circuit arrangement according to Claim 16, **characterized in that** the output signal of the comparator (6) is fed to the adder (9) via a low-pass filter (8).

18. Use of a circuit arrangement according to one of Claims 7-17 in a radio-frequency receiver, a received signal received by a radio-frequency receiving unit (2) and mixed down to a baseband signal being fed to the analogue/digital converter (4) for conversion into a digital signal via the amplifier means (3) of the circuit arrangement.

## Revendications

1. Procédé pour régler un niveau de signal envoyé à un convertisseur analogique-numérique,
avec les étapes suivantes :
a) surveillance d'un signal de sortie, comprenant plusieurs bits, du convertisseur analogique-numérique et détection du taux avec lequel, pour un bit surveillé, il apparaît une valeur changée par rapport à la valeur du bit de poids maximal,
b) réglage du niveau de signal envoyé au convertisseur analogique-numérique en fonction du résultat de la surveillance de telle sorte que le niveau du signal de sortie reste à l'intérieur d'un certain domaine et réglage du niveau de signal envoyé au convertisseur analogique-numérique (4) en fonction du taux détecté à l'étape a),
**caractérisé par le fait que**
on mesure une valeur moyenne pour le taux du bit surveillé,
on applique à un multiplexeur (15) comme valeurs d'entrée les valeurs fixes + 1 et - 1 qui sont transmises sélectivement, en fonction du taux mesuré, à une sortie du multiplexeur (15), et
un accumulateur (16) reçoit la valeur d'entrée transmise par le multiplexeur (15), change en conséquence son état de compteur et règle en fonction de son état de compteur le niveau de signal envoyé au convertisseur analogique-numérique.

2. Procédé selon la revendication 1,
**caractérisé par le fait que**, à l'étape b), on compare le taux détecté à l'étape a) à une valeur de consigne (SP) qui correspond à un taux de consigne afin de régler en fonction du résultat de la comparaison le niveau de signal envoyé au convertisseur analogique-numérique (4).

3. Procédé selon la revendication 2,
**caractérisé par le fait que**, à l'étape b), on choisit comme valeur de consigne (SP) pour le taux un taux correspondant à une probabilité moyenne de changement < 50 % de telle sorte que le niveau de signal envoyé au convertisseur analogique-numérique (4) est réglé de telle sorte que le bit surveillé du signal de sortie du convertisseur analogique-numérique (4) change en moyenne moins d'un cycle d'horloge (CLK) sur deux du convertisseur analogique-numérique (4).

4. Procédé selon la revendication 3,
**caractérisé par le fait que**, à l'étape b), on choisit comme valeur de consigne (SP) pour le taux un taux correspondant à une probabilité moyenne de changement de 25 % de telle sorte que le niveau de signal envoyé au convertisseur analogique-numérique (4) est réglé de telle sorte que le bit surveillé du signal de sortie du convertisseur analogique-numérique (4) change en moyenne un cycle d'horloge (CLK) sur quatre du convertisseur analogique-numérique (4).

5. Procédé selon la revendication 4,
**caractérisé par le fait que**
le convertisseur analogique-numérique (4) fournit un signal de sortie sur 8 bits, et
à l'étape a), on détecte le taux de changement du sixième bit du signal de sortie du convertisseur analogique-numérique (4).

6. Procédé selon la revendication 2,
**caractérisé par le fait que**
à l'étape b), on augmente le niveau de signal envoyé au convertisseur analogique-numérique (4) si le taux détecté à l'étape a) est inférieur à la valeur de consigne (SP), et
à l'étape b), on réduit le niveau de signal envoyé au convertisseur analogique-numérique (4) si le taux détecté à l'étape a) est supérieur à la valeur de consigne (SP).

7. Circuit pour régler le niveau de signal envoyé à un convertisseur analogique-numérique,
avec des moyens d'amplification (3) pour envoyer au convertisseur analogique-numérique (4) un signal d'entrée analogique ayant un certain niveau de signal,
avec des moyens de surveillance (10 à 13) pour surveiller le signal de sortie, comprenant plusieurs bits, du convertisseur analogique-numérique (4), et
avec un circuit de régulation (14 à 16) pour produire un signal de réglage pour les moyens d'amplification (3), le circuit de régulation (14 à 16) produisant en fonction du résultat de surveillance des moyens de surveillance (10 à 13) un signal de réglage pour les moyens d'amplification (3) de telle sorte que le niveau de signal envoyé au convertisseur analogique-numérique (4) reste à l'intérieur d'un certain domaine,
les moyens de surveillance (10 à 13) étant conçus de telle sorte qu'ils détectent le taux avec lequel, pour un bit surveillé, il apparaît une valeur changée par rapport à la valeur du bit de poids maximal, et
le circuit de régulation (14 à 16) étant conçu de telle sorte qu'il produit en fonction du taux détecté par les moyens de surveillance (10 à 13) le signal de réglage pour les moyens d'amplification (3),
**caractérisé par le fait que**
les moyens de surveillance (10 à 13) comprennent un circuit de formation de valeur moyenne (12, 13) pour faire la moyenne temporelle du taux, détecté par le circuit logique (10, 11), du bit surveillé du signal de sortie du convertisseur analogique-numérique (4),
le circuit de régulation comprend un multiplexeur (15) commandé par un signal de sortie du circuit logique (10, 11) et un accumulateur (16),
les valeurs fixes + 1 et - 1 étant appliquées comme valeurs d'entrée au multiplexeur (15) et étant transmises sélectivement, en fonction de la valeur du signal de sortie du circuit logique (10, 11 ), à la sortie du multiplexeur (15), et
l'accumulateur (16) reçoit la valeur d'entrée transmise par le multiplexeur (15), modifie en conséquence son état de compteur et produit en fonction de son état de compteur le signal de réglage pour les moyens d'amplification (3).

8. Circuit selon la revendication 7,
**caractérisé par le fait que**
le convertisseur analogique-numérique (4) fournit un signal de sortie sur 8 bits, et
les moyens de surveillance (10 à 13) détectent le taux du sixième bit, en commençant à compter par le plus faible, du signal de sortie du convertisseur analogique-numérique (4).

9. Circuit selon l'une des revendications 7 ou 8,
**caractérisé par le fait que** les moyens de surveillance (10 à 13) comprennent un circuit logique (10, 11) qui, pour la détermination du taux, détecte un changement du bit de poids plus faible par rapport au bit de poids maximal du signal de sortie du convertisseur analogique-numérique (4).

10. Circuit selon la revendication 9,
**caractérisé par le fait que** le circuit logique (10, 11) comprend une porte XOR (10) à laquelle sont envoyés comme signaux d'entrée le bit de poids plus faible et le bit de poids maximal du signal de sortie du convertisseur analogique-numérique (4).

11. Circuit selon la revendication 10,
**caractérisé par le fait que** le circuit logique (10, 11) comprend une porte OR (11) à laquelle sont envoyés comme signaux d'entrée le signal de sortie de la porte XOR (10) et un signal de débordement du convertisseur analogique-numérique (4).

12. Circuit selon l'une des revendications 7 à 11,
**caractérisé par le fait que** le circuit de formation de valeur moyenne (12, 13) comprend une bascule monostable (12) et un filtre passe-bas (13) branché en série avec celle-ci, la bascule monostable (12) étant reliée au circuit logique (10, 11) et étant soumise à la même horloge (CLK) que le convertisseur analogique-numérique (4).

13. Circuit selon l'une des revendications 7 à 12,
**caractérisé par le fait que** le circuit de régulation comprend un régulateur PI (14) qui compare le taux détecté par les moyens de surveillance (10 à 13) à une valeur de consigne (SP) et qui produit en fonction de l'écart entre le taux détecté par les moyens de surveillance (10 à 13) et la valeur de consigne le signal de réglage pour les moyens d'amplification (3).

14. Circuit selon la revendication 13,
**caractérisé par le fait que**
le régulateur PI (14) produit pour les moyens d'amplification (3) un signal de réglage augmentant le niveau de signal envoyé au convertisseur analogique-numérique (4) si le taux détecté par les moyens de surveillance (10 à 13) est inférieur à la valeur de consigne (SP), et
le régulateur PI (14) produit pour les moyens d'amplification (3) un signal de réglage réduisant le niveau de signal envoyé au convertisseur analogique-numérique (4) si le taux détecté par les moyens de surveillance (10 à 13) est supérieur à la valeur de consigne (SP).

15. Circuit selon l'une des revendications 7 à 14,
**caractérisé par le fait que** l'accumulateur (16) est un accumulateur à 20 bits, les huit bits supérieurs de l'état de compteur de l'accumulateur (16) étant envoyés comme signal de réglage aux moyens d'amplification (3).

16. Circuit selon l'une des revendications 7 à 15,
**caractérisé par le fait que**
une unité de formation de valeur absolue (5) est reliée à la sortie du
convertisseur analogique-numérique (4) pour former la valeur absolue du signal de sortie du convertisseur analogique-numérique (4),
un comparateur (6) est relié à la sortie de l'unité de formation de valeur absolue (5) pour comparer la valeur absolue fournie par l'unité de formation de valeur absolue (5) à une valeur de consigne (SP), et
un additionneur est prévu pour additionner le signal de sortie du comparateur (6) et le signal de sortie de l'accumulateur (16), le résultat de l'additionneur (9) étant envoyé comme signal de réglage aux moyens d'amplification (3).

17. Circuit selon la revendication 16,
**caractérisé par le fait que** le signal de sortie du comparateur (6) est envoyé à l'additionneur (9) par l'intermédiaire d'un filtre passe-bas (8).

18. Utilisation d'un circuit selon l'une des revendications 7 à 17 dans un récepteur à haute fréquence,
un signal reçu, reçu par une unité de réception à haute fréquence (2) et abaissé en un signal en bande de base, étant envoyé par l'intermédiaire des moyens d'amplification (3) du circuit au convertisseur analogique-numérique (4) destiné à la conversion en un signal numérique.
